# FASCICULE DE BREVET EUROPEEN

(11) **EP 2 288 925 B1**
(45) Date de publication et mention de la délivrance du brevet: **22.04.2015**
(21) Numéro de dépôt: 09766047.6
(22) Date de dépôt: 22.05.2009
(51) Int. Cl.: G01R 15/18, G01R 33/04, G01R 33/06, G01R 33/18

(54) **CAPTEUR DE CIRCULATION DE CHAMPS MAGNÉTIQUES PERMANENTS OU VARIABLES ET ALTERNATIFS ET CAPTEUR DE COURANT METTANT EN OEUVRE UN TEL CAPTEUR**
SENSOR FÜR PERMANENTE ODER VARIABLE MAGNETFELDZIRKULATION UND STROMSENSOR MIT DERARTIGEM SENSOR
PERMANENT OR VARIABLE ALTERNATING MAGNETIC FIELD CIRCULATION SENSOR, AND CURRENT SENSOR IMPLEMENTING SUCH A SENSOR

(30) Priorité: 22.05.2008 FR 0853338
(43) Date de publication de la demande: 02.03.2011
(73) Titulaire: Neelogy, 37550 Saint-Avertin (FR)
(72) Inventeur: CIMA, Lionel, F-92290 Chatenay-Malabry (FR); MANIOULOUX, Yohan, F-36000 Grenoble (FR)
(74) Mandataire: Pontet Allano & Associes
(86) Numéro de dépôt international: PCT/FR2009/050953
(87) Numéro de publication internationale: WO 2009/153485

(56) Documents cités:
- EP-A- 0 288 998
- EP-A- 1 512 981
- EP-A- 1 522 827
- WO-A-2007/061390
- FR-A- 2 487 969
- US-A- 5 469 058
- US-A- 5 815 391
- US-A1- 2004 201 373
- US-A1- 2005 134 290
- US-A1- 2006 082 356
- US-B1- 6 566 855

## Description

La présente invention concerne le domaine technique des capteurs utilisés pour mesurer des grandeurs magnétiques telles que le champ magnétique afin de connaître une valeur intrinsèque de ce dernier ou encore d'en extrapoler des valeurs quantifiant les phénomènes physiques qui en sont à l'origine. Dans une application préférée mais non exclusive, l'invention concerne les capteurs de courant qui déterminent l'intensité d'un courant électrique circulant dans un conducteur à partir du champ magnétique rayonné par ce dernier.

Ainsi, certains capteurs tels que les capteurs de courant de type Rogowski déterminent la valeur d'un courant à partir de la circulation du champ magnétique généré par ledit courant dans un transducteur, encore appelé sonde Rogowski. Un tel transducteur de type Rogowski comprend généralement une bobine allongée s'étendant autour d'un noyau souple allongé constitué d'un matériau non magnétique. Le transducteur Rogowski est alors associé à une électronique qui détermine à partir des grandeurs électriques mesurées aux bornes de la bobine la valeur du flux magnétique circulant à l'intérieur de ladite bobine pour en déduire, lorsque la bobine entoure un conducteur électrique, l'intensité du courant circulant dans ce conducteur.

De tels capteurs Rogowski donnent satisfaction pour les mesures de courants alternatifs mais présentent toutefois l'inconvénient de ne pas être adaptés à la mesure de courants continus. Afin de remédier à cet inconvénient, il a été proposé, par une démande de brevet US 2004/0201373, de mettre en oeuvre un capteur comprenant un élément de détection de type Flux Gate présentant une perméabilité magnétique élevée ainsi qu'un noyau magnétique formé d'un ruban en matériel à perméabilité magnétique élevée qui entoure l'élément de détection de type Flux Gate. Cependant la mise en oeuvre de matériau magnétique à perméabilité magnétique relative élevée implique le recours à des alliages magnétiques particulièrement onéreux et sensibles aux contraintes mécaniques extérieures. Il est donc apparu le besoin d'un nouveau type de capteur adapté pour la mesure de courants alternatifs et de courants continus qui présente un coût de fabrication réduit par rapport aux capteurs mettant en oeuvre des matériaux à perméabilité élevée et qui soit moins sensible aux contraintes mécaniques externes et donc moins fragile que les capteurs connus.

Afin d'atteindre cet objectif, l'invention concerne un capteur de circulation de champ magnétique comprenant :
- des moyens d'excitation magnétique comprenant :
   - au moins une bobine d'excitation allongée s'étendant autour d'un noyau magnétique souple allongé et constitué par un matériau magnétique souple présentant une faible perméabilité magnétique relative et comprenant une matrice souple ou flexible dans laquelle sont dispersées des particules magnétiques,
   - une unité de génération d'un courant d'excitation raccordée à la bobine d'excitation pour générer un champ magnétique d'excitation dans le noyau sur sensiblement toute la longueur de la bobine,
- des moyens de mesure comprenant :
   - au moins un transducteur de mesure magnétique en couplage magnétique avec les moyens d'excitation magnétique, et
   - une unité de mesure raccordée au transducteur de mesure et adaptée pour exploiter les grandeurs électriques issues du transducteur de mesure.

Il doit être noté que le capteur selon l'invention est un capteur de circulation c'est-à-dire que les moyens de mesure sont adaptés pour intégrer la valeur du champ magnétique le long du noyau ou tout au moins sur la longueur du noyau couverte par la bobine d'excitation.

La mise en oeuvre des moyens d'excitation magnétique permet de générer dans le noyau un champ magnétique d'excitation qui sera modulé par le champ magnétique à mesurer grâce aux non-linéarités magnétiques introduites par les particules magnétiques du noyau magnétique à faible perméabilité magnétique relative. La circulation du champ magnétique modulé sera déterminée par les moyens de mesure qui réalisent une intégration des valeurs du champ magnétique le long du noyau magnétique allongé. Grâce à cette excitation, le capteur selon l'invention est sensible aux circulations de champs magnétiques tant permanents que variables.

De plus, la mise en oeuvre d'un noyau magnétique comprenant une matrice souple dans laquelle sont dispersées des particules magnétiques permet d'obtenir un capteur qui est très peu, voire pas, sensible aux contraintes mécaniques ou déformations subies par son noyau.

Par ailleurs, il doit être souligné que les inventeurs ont démontré qu'il est possible de détecter ou de mesurer des champs magnétiques ainsi que des champs magnétiques permanents variables en mettant en oeuvre des matériaux à faible perméabilité magnétique relative alors que jusqu'à présent il était utilisé des matériaux à perméabilité magnétique relative élevée comme cela est décrit par la demande US 2004/0201373.

Selon une caractéristique de l'invention, les particules du noyau du transducteur présentent des dimensions sub-micrométriques et de préférence d'ordre nanométrique. La mise en oeuvre d'une telle taille de particules permet l'obtention d'une faible voire très faible perméabilité du noyau ainsi qu'une diminution de l'hystérésis, ainsi qu'une réduction de la sensibilité aux entrefers, ainsi qu'une augmentation de la plage de fonctionnement du capteur avant saturation du capteur. Il est important de remarquer que, à la différence des capteurs de type Flux Gate, les particules de dimensions sub-micrométriques sont choisies pour introduire une modulation par leurs non linéarités, sans nécessairement saturer le matériau du noyau magnétique. Ainsi, le capteur de circulation de champ magnétique augmente sa plage de fonctionnement linéaire, c'est à dire que en présence de deux sources de champs externes, le capteur de circulation de champ magnétique fournit une information proportionnelle à la somme des deux circulations de champs magnétiques externes.

Dan le même sens, selon une autre caractéristique de l'invention, les particules du noyau du transducteur forment des agrégats qui présentent des dimensions sub-micrométriques et de préférence d'ordre nanométrique.

Selon encore une autre caractéristique de l'invention, le noyau présente un comportement superparamagnétique. La mise en oeuvre d'un tel noyau superparamagnétique présente l'avantage de mettre à profit l'absence sensiblement complète d'hystérésis, ce qui permet d'augmenter la précision du capteur pour les faibles valeurs de circulations de champ.

Selon l'invention, la bobine d'excitation peut être réalisée de diverses manières. Ainsi, la bobine d'excitation peut comprendre un conducteur enroulé autour du noyau selon des spires jointives ou non, les extrémités de raccordement du conducteur étant alors situées chacune à une extrémité différente du corps allongé. Ces extrémités sont ensuite rapprochées pour permettre leur raccordement à l'unité d'excitation et/ou à l'unité de mesure lorsque le noyau est refermé sur lui-même de manière à entourer le ou les conducteurs électriques dans lesquels circule un courant à mesurer. Bien entendu, un tel mode de réalisation de la bobine d'excitation n'est pas strictement nécessaire ni même le seul envisageable.

Ainsi, selon une forme de réalisation de l'invention, la bobine d'excitation comprend au moins un conducteur aller enroulé autour du noyau de manière à s'étendre d'une première extrémité à une deuxième extrémité du noyau et au moins un conducteur de retour s'étendant depuis la deuxième extrémité du conducteur aller pour revenir jusqu'à proximité de la première extrémité.

Selon une variante de cette forme de réalisation, le conducteur de retour s'étend dans le noyau sensiblement le long de son axe central Δ. Ainsi le conducteur aller, le noyau et le conducteur présente une géométrie coaxiale particulièrement adaptée à une fabrication industrielle automatisée.

Selon une autre variante de cette forme de réalisation, le conducteur de retour est bobiné autour du noyau. Ce bobinage du conducteur de retour permet d'augmenter le champ d'excitation. Le conducteur de retour sera alors bobiné afin d'éviter une neutralisation du champ d'excitation, généré par le conducteur aller, par le champ d'excitation généré par le conducteur de retour. Par ailleurs, le conducteur de retour formera de préférence le même nombre de spires que le conducteur aller, et sera de préférence également enroulé selon un même pas que les spires soient jointives ou non.

Selon l'invention, les moyens de mesure peuvent être réalisés de toute manière appropriée. Ainsi, les moyens de mesures peuvent comprendre plusieurs transducteurs à effet Hall répartis dans le noyau et reliés à l'unité de mesure de manière à intégrer les valeurs locales du champ magnétique dans ce dernier. Les transducteurs à effet Hall seront, de préférence, uniformément répartis dans le noyau pour assurer une intégration homogène du champ magnétique. Bien entendu, il pourrait être envisagé de mettre en oeuvre d'autres types de transducteurs magnétiques discrets tels que des magnétorésistances par exemple.

Selon une forme de réalisation de l'invention, le transducteur de mesure magnétique comprend au moins un conducteur enroulé autour du noyau magnétique souple allongé. La mise en oeuvre d'un tel transducteur continûment réparti le long du noyau magnétique 11 permet d'effectuer une intégration continue du champ magnétique dans le noyau ce qui contribue entre autres à la précision et à la linéarité du capteur.

Selon une caractéristique de cette forme de réalisation, la bobine d'excitation forme en partie au moins le transducteur magnétique de mesure. Il est ainsi possible de réduire les coûts de fabrication du capteur selon l'invention.

Selon une autre caractéristique de cette forme de réalisation, le transducteur de mesure comprend au moins une bobine de mesure distincte de la bobine d'excitation et formée par un conducteur de mesure enroulé autour du noyau. De manière préférée, la bobine de mesure s'étend sur la même portion du noyau magnétique que la bobine d'excitation. L'utilisation d'une bobine de mesure distincte de la bobine d'excitation présente l'avantage qu'il ne circule alors sensiblement pas de courant dans la bobine de mesure, permettant ainsi de s'affranchir des effets parasites de la résistance du bobinage dans la détermination de la circulation du champ magnétique.

Selon une caractéristique de l'invention, chaque conducteur enroulé forme des spires qui sont chacune espacées de la suivante d'une distance inférieure ou égale à 4 fois le diamètre du fil conducteur constitutif du bobinage et de préférence d'une distance inférieure ou égale à 2 fois le diamètre du fil conducteur. De tels paramètres d'enroulement permettent, dans le cadre de la bobine d'excitation, d'obtenir une bonne homogénéité du champ d'excitation dans le noyau. Dans le cadre de la mesure, ces paramètres permettent d'assurer une intégration plus homogène du champ magnétique le long du noyau et donc d'augmenter la sensibilité du capteur de circulation selon l'invention.

Selon une autre caractéristique de l'invention, au moins un conducteur enroulé forme des spires jointives. Dans le cadre de la mesure, cette caractéristique correspond à une configuration permettant une intégration du champ magnétique homogène sur toute la longueur du transducteur de mesure et permet donc une mesure de la circulation du champ magnétique dans le noyau sans discontinuité.

Selon encore une autre caractéristique de l'invention, le capteur comprend des moyens de génération d'un champ de contre-réaction adaptés pour maintenir une circulation de champ magnétique sensiblement nulle dans le noyau magnétique, et connectés à une bobine du capteur.

Les moyens de contre-réaction peuvent alors être connectés à la bobine d'excitation ou encore à une autre bobine qui entoure le noyau et s'étend sensiblement sur toute la longueur de la bobine d'excitation. La mise en oeuvre de tels moyens de contre-réaction est particulièrement avantageuse pour réduire l'influence de la température sur les performances du capteur de circulation de champ magnétique.

Selon encore une autre caractéristique de l'invention, le capteur comprend des moyens de mesure de la température afin de compenser l'influence de celle-ci.

Selon une caractéristique de l'invention visant à permettre des mesures différentielles, le capteur de circulation de champ magnétique comprend au moins deux ensembles de géométries sensiblement identiques chacun formé par l'association d'une bobine d'excitation, d'un noyau magnétique et d'un transducteur de mesure et de préférence deux ensembles seulement..

Selon une autre caractéristique de l'invention, le capteur comprend au moins quatre ensembles sensiblement identiques chacun formé par l'association d'une bobine d'excitation, d'un noyau magnétique et d'un transducteur de mesure. La mise en oeuvre de quatre ensembles d'excitation et de mesure permet d'effectuer avec les transducteurs une mesure basée sur un pont de Wheaston.

Les ensembles sensiblement identiques peuvent alors êtres placés dans différents plans qui ne sont pas nécessairement parallèles les uns des autres. Dans une variante de réalisation, certains au moins et de préférence tous les ensembles sont sensiblement parallèles entre eux.

Selon encore une autre caractéristique de l'invention, le capteur comprend au moins un transducteur de type Rogowski raccordé à l'unité de mesure. Un tel transducteur de type Rogowski comprend par exemple au moins une bobine allongée qui s'étend autour d'un noyau non magnétique souple allongé et qui est raccordée aux moyens de mesure. De manière préférée mais non strictement nécessaire le transducteur Rogowski sera disposé sensiblement parallèlement au transducteur d'excitation magnétique. La mise en oeuvre d'un tel transducteur de type Rogowski dans un capteur de circulation selon l'invention permet à ce dernier de mesurer avec une plus grande bande passante la circulation de champs variables hautes fréquences. Ainsi le capteur selon l'invention est adapté pour mesurer avec précision la circulation de champs permanents et de champs variables à basse ou haute fréquence.

Selon encore une autre caractéristique de l'invention, le capteur de circulation de champ magnétique comprend des moyens de connexion entre les transducteurs et les unités d'excitation et de mesure. De manière préférée mais non strictement nécessaire, ces moyens de connexion sont réversibles de manière à permettre plusieurs connexion et déconnexion successives des transducteurs aux unités d'excitation, de mesure et, éventuellement, aux moyens de contre-réaction.

Selon une caractéristique de l'invention, le capteur de circulation comprend des moyens de fermeture en boucle du noyau magnétique. De tels moyens de fermeture permettent alors de maintenir rapprochées les extrémités opposées du noyau pour par exemple entourer en partie au moins un conducteur électrique ou un ensemble de conducteurs électriques pour mesurer la circulation du champ magnétique engendré par un ou des courants électriques qui y circulent comme cela peut être utile dans des applications de mesure de courant.

L'invention concerne également un capteur de courants continus ou variables mettant en oeuvre un capteur de circulation de champ magnétique selon l'invention dont les moyens de mesure sont adaptés pour mesurer un courant circulant dans un conducteur autour duquel l'ensemble, formé par la bobine d'excitation et noyau, est fermé en boucle.

Bien entendu, les différentes caractéristiques, formes et variantes de réalisation de l'invention peuvent être associées les unes avec les autres selon diverses combinaisons dans la mesure où elles ne sont pas incompatibles ou exclusives les unes des autres.

Par ailleurs, diverses autres caractéristiques de l'invention ressortent de la description ci-dessous effectuée en référence aux dessins annexés qui illustrent des formes non limitatives de réalisation d'un capteur de circulation de champ magnétique selon l'invention et de transducteurs constitutifs d'un tel capteur.
La figure 1 est une perspective schématique d'un capteur selon l'invention mettant en oeuvre un seul noyau magnétique.
La figure 2 est une coupe longitudinale du transducteur ou de l'ensemble noyau-bobine constitutif du capteur illustré à la figure 1.
La figure 3 est une coupe schématique du capteur illustré à la figure 1 dont le transducteur ou l'ensemble noyau bobine est fermé en boucle autour d'un conducteur électrique de manière à former un capteur de courant.
La figure 4 est une coupe axiale partielle d'un transducteur selon l'invention montrant une caractéristique constructive de ce dernier.
Les figures 5 à 9 illustrent des variantes de réalisation d'un transducteur constitutif d'un capteur selon l'invention.
Les figures 10 et 11 montrent en coupe longitudinale l'association de respectivement deux et quatre transducteurs ou ensemble noyau-bobine selon l'invention parallèles entre eux et destinés à être intégrés à un capteur de circulation de champ magnétique selon l'invention.
La figure 12 est une coupe longitudinale partielle d'un transducteur disposé parallèlement à un transducteur de type Rogowski de manière à être intégré à un capteur de circulation de champ magnétique selon l'invention.

Sur les figures, les différents éléments communs aux diverses variantes ou formes de réalisation portent les mêmes références.

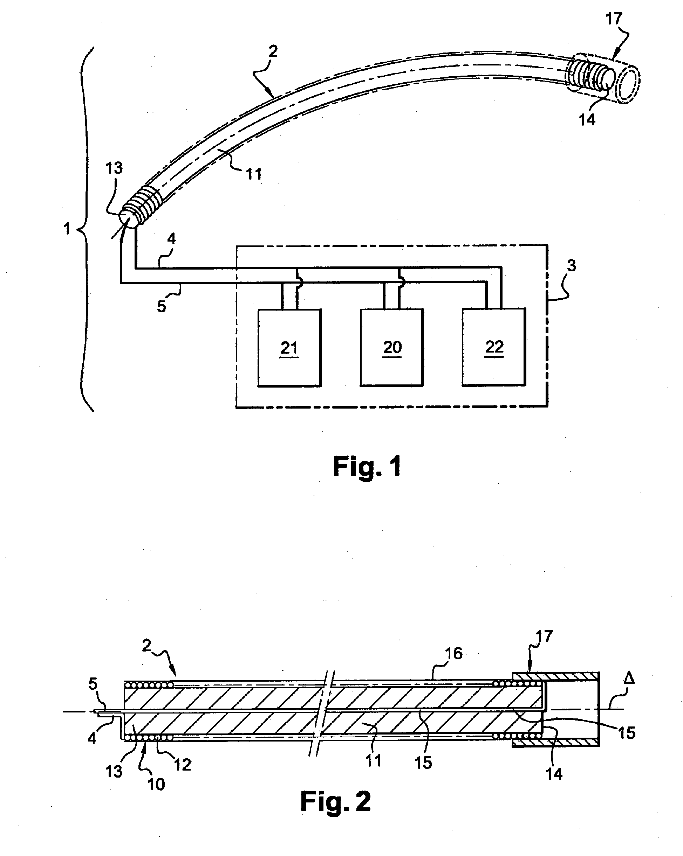

Un capteur de circulation de champ magnétique selon l'invention, tel qu'illustré schématiquement à la figure 1 et désigné dans son ensemble par la référence 1, comprend, d'une part, un ensemble de transduction 2 et, d'autre part, une unité électronique 3 raccordée par des fils ou câbles électriques 4, 5 à l'ensemble de transduction 2.

L'ensemble de transduction 2 comprend une bobine allongée 10 enroulée autour d'un noyau magnétique 11. Au sens de l'invention on entend par bobine allongé une bobine qui présente une longueur supérieure à deux fois son diamètre et par exemple une longueur supérieure à cinq fois voire dix fois le diamètre de la bobine. De manière préférée la bobine s'étendra sur la majeure partie du noyau magnétique. Ainsi, le noyau magnétique 11 possède une longueur égale ou supérieure à celle de la bobine 10. Afin de faciliter la réalisation de l'ensemble de transduction 2 mais également rendre plus aisée la mise en oeuvre du capteur, le noyau magnétique 11 possède un caractère souple au moins avant sa première mise en oeuvre. Par caractère souple, il faut entendre que le noyau 11 est souple ou flexible à température ambiante (20°C) et peut donc être déformé à la main sans outillage spécial. Selon l'invention, le noyau magnétique 11 est alors constitué par un matériau souple comprenant une matrice souple ou flexible en matériau polymère dans laquelle sont dispersées des particules magnétiques qui confèrent leur caractère magnétique au noyau.

La matrice souple peut alors être réalisé, selon les applications envisagées pour le capteur selon l'invention, soit en un matériau plastique encore appelé plastomère ou soit en caoutchouc naturel ou synthétique encore appelé élastomère. La matrice peut ainsi être en matière plastique choisie parmi les thermoplastiques ou les thermodurcissables. A titre d'exemple, la matrice peut être choisie parmi les thermodurcissables suivants : phénoplaste, aminoplaste, résine époxy, polyester insaturé, polyuréthane réticulé alkyl. La matrice peut être également choisie parmi les thermoplastiques suivants : polyvinylique, chlorure de polyvinyle, acétate de polyvinyle, alcool polyvinylique, polyester et copolymère, polymère acrylique, polyoléofine, dérivé cellulosique, polyamide. La matrice peut aussi être choisie parmi les polymères suivants : polymère fluoré, silicone, caoutchouc synthétique, polyester saturé, polyuréthane linéaire, polycarbonate, polyacétal, oxyde de polyphénylène, polysulfone, polyester sulfone, polysulfure de phénylène, polyimide et élastomère.

Afin de faciliter la fabrication et la mise en oeuvre de la bobine, le matériau constitutif de la matrice sera choisi pour présenter de préférence un caractère flexible pendant toute la durée de vie du capteur. Toutefois, il pourrait être envisagé de mettre en oeuvre pour la matrice un matériau susceptible d'être durci ou rigidifié ultérieurement de manière à devenir sensiblement indéformable après mis en place du transducteur sur son lieu d'utilisation. Ainsi, il pourrait être envisagé d'utiliser en tant que matrice, un matériau thermodurcissable subissant, après réalisation de la bobine, un traitement thermique pour lui conférer une forme particulière en étant éventuellement élastiquement déformable.

Afin de conférer un caractère magnétique au noyau, le matériau constitutif de ce dernier comprend également des particules magnétiques dispersées à l'intérieur de la matrice. Les particules magnétiques seront par exemple choisies parmi les particules d'oxyde de fer, les particules d'oxyde mixte de fer et d'un autre métal, des particules d'oxyde de nickel, de cobalt ou des oxydes mixtes de ces métaux. Les oxydes mixtes de fer seront par exemple des oxydes mixtes de fer et d'un autre métal choisi parmi Mn, Ni, Zn, Bi, Cu, Co. Les particules magnétiques pourront également être choisies parmi les particules d'oxyde de fer de type Fe₃O₄ et/ou F₂O₃. Les particules magnétiques pourront aussi être choisies parmi les particules d'alliage métallique de type FeₓNi₍₁₋ₓ₎, CoₓNi₍₁₋ₓ₎ ou Fe₂₀Ni₈₀.

Afin de conférer des propriétés magnétiques isotropes particulières telles qu'une faible perméabilité relative par exemple, inférieure à 100, voire inférieure à 10, voire inférieure à 5, ou encore telles qu'une non-linéarité avant saturation et un faible hystérésis, les particules du noyau seront choisies pour présenter individuellement ou en agrégat des dimensions sub-micrométriques et de préférence d'ordre nanométrique. De manière préférée, les particules magnétiques seront choisies de manière à présenter des dimensions et des concentrations dans la matrice conférant au noyau un comportement superparamagnétique. Par comportement superparamagnétique on entend un comportement superparamagnétique tel que défini par l'ouvrage d'Etienne du Trémolet de Lacheisserie et al. « Magnétisme » TOME 1, publié en 1999 par les éditions « EDP Sciences » à la collection « Grenoble sciences », ISBN 2-86883-463-9.

Selon l'exemple illustré, la bobine 10 comprend un conducteur aller 12 qui s'étend à partir d'une première extrémité 13 du noyau jusqu'à l'extrémité opposée ou deuxième extrémité 14. Le conducteur aller 12 est enroulé en spires jointives autour et le long du noyau 11. Afin de faciliter le raccordement de la bobine 10, à l'unité 3, la bobine 10 comprend un conducteur de retour 15 qui prolonge le conducteur aller 12 à partir de l'extrémité 14 jusqu'à la première extrémité 13. Selon l'exemple illustré, le conducteur de retour 15 s'étend dans le noyau sensiblement le long de l'axe central ou fibre moyenne Δ de ce dernier. Bien entendu il pourrait être envisagé de faire revenir le conducteur de retour à l'extérieur du noyau ou de la bobine en s'étendant sensiblement parallèlement à l'axe central Δ. Afin d'assurer une protection de la bobine et plus particulièrement de son bobinage 12, ce dernier peut être recouvert d'une gaine protectrice 16 pouvant par exemple être constituée par une gaine souple en matériau thermorétractable. L'ensemble noyau-bobine 2 comprend également, selon l'exemple illustré, des moyens 17 de fermeture en boucle formés ici par un manchon tubulaire adapté à l'extrémité 14 et destiné à recevoir l'extrémité 13. Bien entendu, les moyens de fermeture 17 pourraient être réalisés de tout autre manière appropriée, telle que par exemple sous la forme d'un fermoir mécanique permettant un nombre important d'ouvertures et de fermetures.

Comme cela a été indiqué précédemment, la bobine 10 est raccordée à l'unité 3 qui comprend des moyens d'excitation 20 et des moyens de mesure 21. Les moyens d'excitation 20 comprennent une électronique qui génère un courant d'excitation de manière à engendrer un champ magnétique d'excitation dans le noyau 11 et sur toute la longueur de la bobine 10. Dans la mesure où, selon l'exemple illustré, les moyens d'excitation 20 sont directement raccordés à l'unique bobine 10, les champs magnétiques d'excitation, engendrés par le courant d'excitation généré par les moyens 20, s'étendent nécessairement au moins sur toute la longueur de la bobine. Par ailleurs, les moyens de mesure 21 sont raccordés à la bobine 10 parallèlement aux moyens d'excitation 20. Les moyens de mesures 21 sont alors adaptés pour exploiter les grandeurs électriques issues de cette dernière.

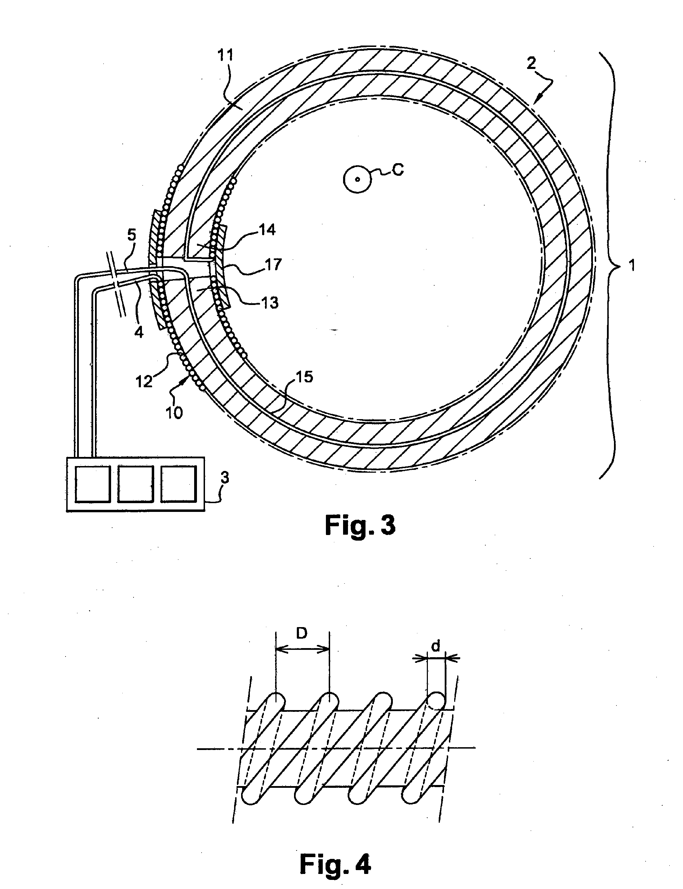

Dans une forme préférée de réalisation mais non exclusive, les moyens de mesure 21 sont adaptés pour déterminer l'intensité d'un courant circulant dans un conducteur C à partir du champ magnétique rayonné par ce dernier et circulant dans la bobine 10. A cet effet, le transducteur 2 est, de préférence et comme le montre la figure 3, fermé en boucle autour du conducteur C à l'intérieur duquel circule le courant à mesurer. Cette fermeture en boucle est réalisée en engageant l'extrémité 13 de l'ensemble noyau-bobine 2 dans le manchon 17 équipant l'extrémité 14. Bien entendu, d'autres moyens de fermeture pourraient être mis en oeuvre pour assurer la mise en place de l'ensemble noyau-bobine 2 autour du conducteur C.

Il est à noter que dans le cadre de la forme de réalisation du capteur 1 décrite précédemment, la bobine 10 assure une double fonction de bobine d'excitation et de mesure. Par ailleurs, il pourrait également être envisagé de mettre en oeuvre des moyens de contre-réaction 22 adaptés pour maintenir le champ magnétique dans le noyau 11 à une valeur sensiblement nulle. Dans le cas illustré fig. 1 à 3, ces moyens de contre-réaction 22 sont raccordés directement à la bobine 10 qui assure alors une troisième fonction de bobine de contre-réaction.

Selon l'exemple illustré, la bobine 10 comprend un conducteur enroulé selon des spires jointives. Toutefois, selon l'invention les spires du conducteur 12 pourraient ne pas être jointives comme le montre la figure 4. De manière préférée, deux spires consécutives seront alors espacées d'une distance D inférieure à quatre fois le diamètre d du conducteur constitutif du bobinage et, de préférence inférieure, à deux fois ce diamètre.

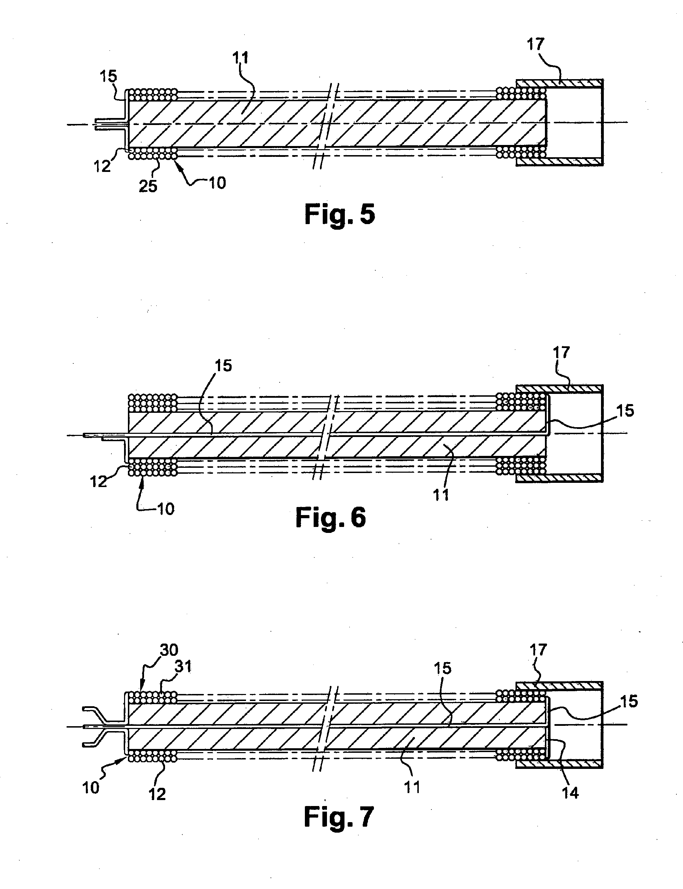

Selon l'exemple décrit en relation avec les figures 1 à 3, le conducteur de retour 15 s'étend au centre du noyau 11. Toutefois, un tel mode de réalisation n'est pas strictement nécessaire à l'obtention d'un transducteur 2 selon l'invention. Ainsi, la figure 5 illustre une autre forme de réalisation de l'ensemble noyau-bobine 2 et plus particulièrement d'une bobine 10, selon laquelle le conducteur de retour 15 est entouré autour du noyau 11 et du conducteur 12 pour former un bobinage de retour 25 qui comprend le même nombre de spires que le conducteur « aller » 12. Les spires du bobinage 25 ou du conducteur de retour 15 sont alors enroulées dans le même sens. Un tel mode de réalisation peut également être envisagé dans le cas où la bobine 10 présente un nombre pair de bobinage à savoir autant de bobinages « aller » que de bobinages « retour ».

Bien entendu, la bobine 10 pourrait comprendre un nombre impair supérieur ou égal à trois de bobinages, comme cela est illustré à la figure 6. Selon cet exemple, la bobine 10 comprend trois bobinages dont le dernier est raccordé au niveau de l'extrémité 14 au conducteur de retour 15 qui s'étend à la l'intérieur du noyau 11.

Selon l'exemple illustré en relation avec les figures 1 à 3, l'ensemble de transduction 2 comprend une seule bobine qui assure les fonctions de d'excitation et de mesure ainsi qu'éventuellement de contre-réaction. Toutefois, les fonctions d'excitation et de mesure ne sont pas nécessairement réalisées par une seule et même bobine.

Ainsi, la figure 7 illustre un ensemble de transduction 2 selon l'invention qui comprend à la fois une bobine d'excitation 10 et une bobine de mesure 30 entourant la bobine d'excitation 10 . Selon cet exemple, la bobine d'excitation 10 comprend un seul bobinage ou conducteur « aller » 12 et un conducteur de retour 15. De la même manière, la bobine de mesure 30 comprend un seul bobinage 31 raccordé au niveau de l'extrémité 14 au conducteur de retour 15.

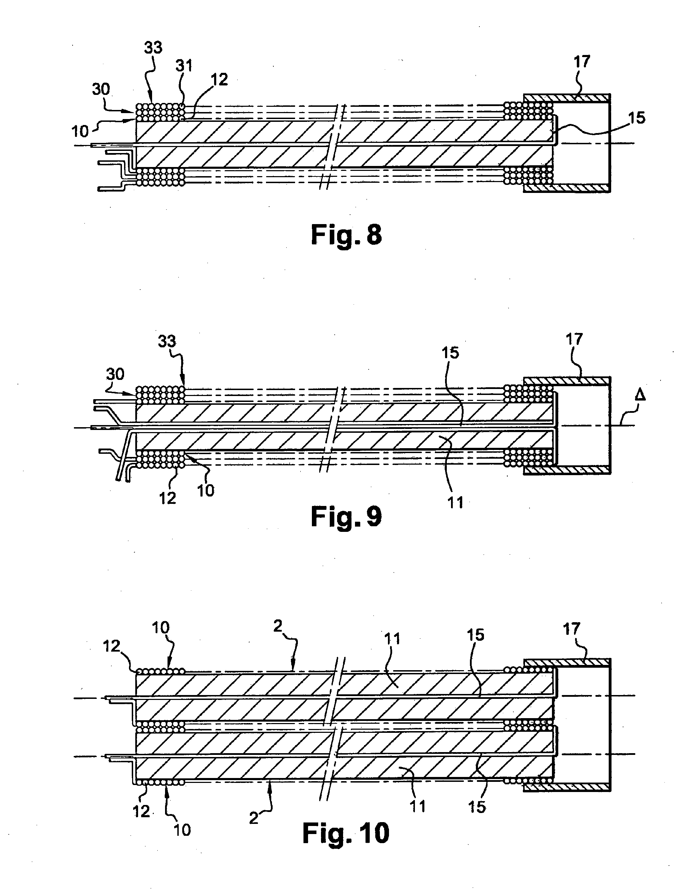

Bien entendu, il pourrait également être envisagé, comme le montre la figure 8 de disposer d'une troisième bobine 33 enroulée autour des bobines 10 et 30 et destinée à former une bobine de contre-réaction. Selon l'exemple illustré, les trois bobines 10, 30 et 33 partagent le même conducteur de retour 15. En revanche, selon l'exemple illustré à la figure 9, chacune des bobines 10, 30, 33 présente son propre conducteur de retour s'étendant dans le noyau 11 sensiblement le long de l'axe central Δ de ce dernier.

Un capteur de circulation de champ magnétique peut comprendre un seul ensemble de transduction 2 ou comme le montre la figure 10, plusieurs, ici deux, ensembles de transduction 2 identiques qui sont disposés de manière à être parallèles l'un à l'autre. Un tel montage permet de réaliser des mesures différentielles.

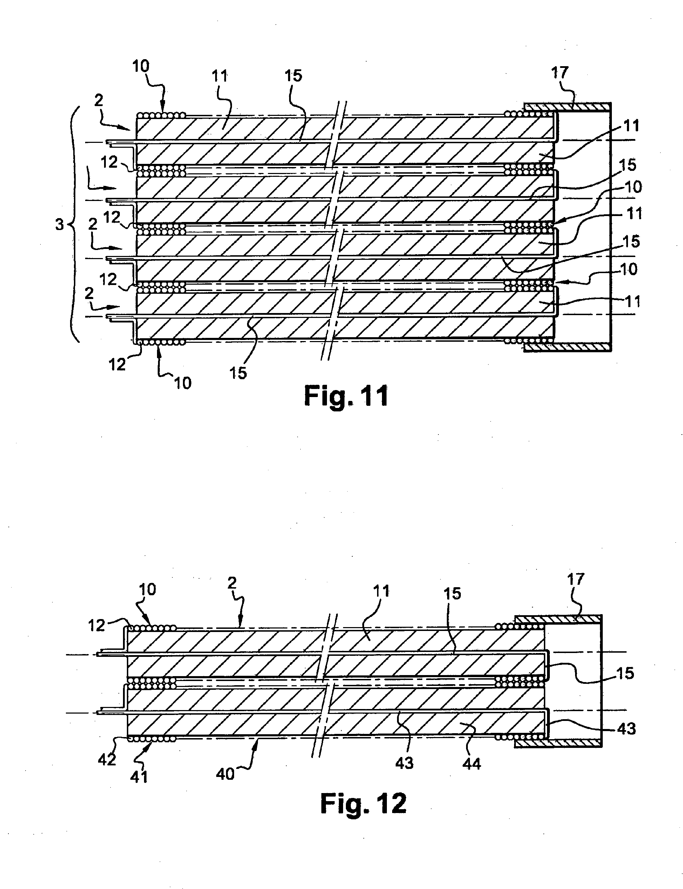

De la même manière la figure 11 montre l'association de quatre ensembles de transduction 2 identiques disposés de manière à être parallèles entre eux. Cette association permet d'effectuer avec les transducteurs une mesure basée sur un pont de Wheaston.

Il est également possible d'associer un ensemble de transduction ou transducteur 2 selon l'invention à un transducteur non magnétique 40 comme le montre la figure 12. Le transducteur non magnétique 40 présente alors une structure mécanique générale sensiblement analogue à celle de l'ensemble de transduction 2 avec un bobine 41 comprenant un conducteur aller 42 bobiné et un conducteur de retour 43. Le transducteur amagnétique 40 diffère du transducteur magnétique 2 en ce que son noyau 44 est non magnétique, et qu'il n'est pas nécessairement excité. Le transducteur 40 s'apparente alors à une sonde ou un transducteur de type Rogowski. Le transducteur 2 et le transducteur de type Rogowski 40 sont tous deux raccordés aux moyens de mesure 21 tandis que seul le transducteur magnétique 2 est raccordé aux moyens d'excitations 20. Il doit être noté que les transducteurs 2 et 40 sont tous deux adaptés à la mesure d'une circulation de champ magnétique, l'appellation magnétique et non magnétique étant ici adoptée en fonction de la nature du noyau.

Bien entendu, diverses autres modifications peuvent être rapportées à l'invention dans le cadre des revendications annexées.

## Revendications

1. Capteur de circulation de champs magnétiques permanents ou variables comprenant :
- des moyens d'excitation magnétique comprenant :
- au moins une bobine d'excitation allongée (10) s'étendant autour d'un noyau magnétique souple (11) allongé et constitué par un matériau magnétique souple, et
- une unité (3, 20) de génération d'un courant d'excitation raccordée à la bobine d'excitation, pour générer un champ magnétique d'excitation dans le noyau sur sensiblement toute la longueur de la bobine, et
- des moyens de mesure comprenant :
- au moins un transducteur de mesure magnétique (10, 30) en couplage magnétique avec les moyens d'excitation magnétique, et
- une unité de mesure (3, 21) connectée au transducteur de mesure magnétique (10, 30) et adaptée pour fournir une mesure de circulation de champ magnétique dans le noyau,
**caractérisé en ce que** le matériau magnétique souple du noyau magnétique souple (11) présente une faible perméabilité magnétique relative et comprend une matrice souple ou flexible dans laquelle sont dispersées des particules magnétiques.

2. Capteur selon la revendication 1, **caractérisé en ce que** la perméabilité magnétique relative du noyau magnétique est inférieure à 100, ou inférieure à 10 ou inférieure à 5.

3. Capteur selon la revendication 1 ou 2, **caractérisé en ce que** les particules magnétiques du noyau (11) présentent des dimensions sub-micrométriques et de préférence d'ordre nanométrique.

4. Capteur selon l'une des revendications 2 à 3, **caractérisé en ce que** le noyau (11) présente un comportement superparamagnétique.

5. Capteur l'une des revendications précédentes, **caractérisé en ce que** la bobine d'excitation (10) comprend au moins un conducteur aller (12) enroulé autour du noyau de manière à s'étendre d'une première extrémité (13) à une deuxième extrémité (14) du noyau et au moins un conducteur de retour (15) s'étendant depuis la deuxième extrémité (14) du conducteur aller (12) pour revenir jusqu'à proximité de la première extrémité (13).

6. Capteur selon la revendication 5, **caractérisé en ce que** le conducteur de retour (15) s'étend dans le noyau sensiblement le long de son axe central (Δ).

7. Capteur selon l'une des revendications 1 à 6, **caractérisé en ce que** le transducteur de mesure magnétique (10, 30) comprend au moins un conducteur enroulé autour du noyau magnétique souple allongé.

8. Capteur de selon l'une des revendications 1 à 7, **caractérisé en ce que** la bobine d'excitation (10) forme en partie au moins le transducteur magnétique de mesure (10).

9. Capteur selon l'une des revendications 1 à 8, **caractérisé en ce que** au moins un conducteur enroulé (12, 25) forme des spires jointives.

10. Capteur selon l'une des revendications 1 à 9, **caractérisé en ce qu'**il comprend des moyens (22) de contre-réaction adaptés pour maintenir la circulation de champ dans une plage prédéfinie, et de préférence sensiblement proche de zéro.

11. Capteur selon l'une des revendications 1 à 10, **caractérisé en ce qu'**il comprend au moins deux ensembles sensiblement identiques chacun formé d'une bobine d'excitation, d'un noyau magnétique et d'un transducteur de mesure associé et de préférence deux ensembles seulement.

12. Capteur selon l'une des revendications 1 à 11, **caractérisé en ce qu'**il comprend au moins un transducteur (40) de type Rogowski raccordé à l'unité de mesure.

13. Capteur selon l'une des revendications 1 à 12 **caractérisé en ce qu'**il comprend des moyens (17) de fermeture en boucle du noyau magnétique.

14. Capteur selon l'une des revendications 1 à 13, **caractérisé en ce qu'**il comprend des moyens de connexion entre les transducteurs et les unités d'excitation (3, 20) et de mesure (3, 21).

15. Capteur de courant continus ou alternatifs, mettant en oeuvre un capteur de circulation de champs magnétiques permanents ou variables selon l'une des revendications 1 à 14, **caractérisé en ce que** les moyens de mesure sont adaptés pour mesurer un courant circulant dans un conducteur (C) autour duquel l'ensemble (2), formé par la bobine d'excitation (10) et noyau (11), est fermé en boucle.

## Patentansprüche

1. Sensor für die Zirkulation von permanenten oder variablen Magnetfeldern, umfassend:
- Mittel zur magnetischen Erregung, die umfassen:
- wenigstens eine langgestreckte Erregerspule (10), die um einen langgestreckten und durch ein nachgiebiges magnetisches Material gebildeten nachgiebigen Magnetkern (11) herum verläuft, und
- eine Einheit (3, 20) zur Erzeugung eines Erregerstroms, die an die Erregerspule angeschlossen ist, um ein Erregermagnetfeld in dem Kern über im Wesentlichen die gesamte Länge der Spule zu erzeugen, sowie
- Messmittel; die umfassen:
- wenigstens einen magnetischen Messwandler (10, 30) in magnetischer Kopplung mit den Mitteln zur magnetischen Erregung, und
- eine Messeinheit (3, 21), die an den magnetischen Messwandler (10, 30) angeschlossen und dazu ausgelegt ist, eine Messung der Magnetfeldzirkulation in dem Kern zu liefern,
**dadurch gekennzeichnet, dass** das nachgiebige magnetische Material des nachgiebigen Magnetkerns (11) eine geringe relative magnetische Permeabilität aufweist und eine nachgiebige oder flexible Matrix umfasst, in der Magnetpartikel fein verteilt sind.

2. Sensor nach Anspruch 1, **dadurch gekennzeichnet, dass** die relative magnetische Permeabilität des Magnetkerns geringer als 100 oder geringer als 10 oder geringer als 5 ist.

3. Sensor nach Anspruch 1 oder 2, **dadurch gekennzeichnet, dass** die Magnetpartikel des Kerns (11) submikrometrische Abmessungen und vorzugsweise im Nanometerbereich aufweisen.

4. Sensor nach einem der Ansprüche 2 bis 3, **dadurch gekennzeichnet, dass** der Kern (11) ein superparamagnetisches Verhalten aufweist.

5. Sensor nach einem der vorhergehenden Ansprüche, **dadurch gekennzeichnet, dass** die Erregerspule (10) wenigstens einen Hinleiter (12), der so um den Kern gewickelt ist, dass er sich von einem ersten Ende (13) zu einem zweiten Ende (14) des Kerns erstreckt, sowie wenigstens einen Rückleiter (15) umfasst, der sich von dem zweiten Ende (14) des Hinleiters (12) aus erstreckt, um bis in die Nähe des ersten Endes (13) zurückzukommen.

6. Sensor nach Anspruch 5, **dadurch gekennzeichnet, dass** der Rückleiter (15) sich in dem Kern im Wesentlichen entlang seiner Mittelachse (Δ) erstreckt.

7. Sensor nach einem der Ansprüche 1 bis 6, **dadurch gekennzeichnet, dass** der magnetische Messwandler (10, 30) wenigstens einen um den langgestreckten, nachgiebigen Magnetkern gewickelten Leiter umfasst.

8. Sensor nach einem der Ansprüche 1 bis 7, **dadurch gekennzeichnet, dass** die Erregerspule (10) wenigstens teilweise den magnetischen Messwandler (10) bildet.

9. Sensor nach einem der Ansprüche 1 bis 8, **dadurch gekennzeichnet, dass** wenigstens ein gewickelter Leiter (12, 25) nebeneinander liegende Windungen bildet.

10. Sensor nach einem der Ansprüche 1 bis 9, **dadurch gekennzeichnet, dass** er Gegenkopplungsmittel (22) umfasst, die dazu ausgelegt sind, die Feldzirkulation in einem vordefinierten Bereich und vorzugsweise im Wesentlichen nahe Null zu halten.

11. Sensor nach einem der Ansprüche 1 bis 10, **dadurch gekennzeichnet, dass** er wenigstens zwei im Wesentlichen identische Anordnungen, jeweils gebildet von einer Erregerspule, von einem Magnetkern und von einem zugeordneten Messwandler, und vorzugsweise nur zwei Anordnungen umfasst.

12. Sensor nach einem der Ansprüche 1 bis 11, **dadurch gekennzeichnet, dass** er wenigstens einen Wandler (40) vom Typ Rogowski umfasst, der an die Messeinheit angeschlossen ist.

13. Sensor nach einem der Ansprüche 1 bis 12, **dadurch gekennzeichnet, dass** er Mittel (17) zum schleifenförmigen Schließen des Magnetkerns umfasst.

14. Sensor nach einem der Ansprüche 1 bis 13, **dadurch gekennzeichnet, dass** er Verbindungsmittel zwischen den Wandlern und den Erreger- (3, 20) und Messeinheiten (3, 21) umfasst.

15. Gleich- oder Wechselstromsensor, der einen Sensor für die Zirkulation von permanenten oder variablen Magnetfeldern nach einem der Ansprüche 1 bis 14 verwendet, **dadurch gekennzeichnet, dass** die Messmittel dazu ausgelegt sind, einen Strom zu messen, der in einem Leiter (C) fließt, um den herum die durch die Erregerspule (10) und Kern (11) gebildete Anordnung (2) schleifenförmig geschlossen ist.

## Claims

1. Permanent or variable magnetic field circulation sensor comprising:
- means of magnetic excitation comprising:
- at least one elongated excitation coil (10) extending around an elongated supple magnetic core (11) and constituted by a supple magnetic material, and
- an excitation current generation unit (3, 20) coupled to the excitation coil in order to generate an excitation magnetic field in the core over substantially the entire length of the coil,
- means of measurement including:
- at least one magnetic measuring transducer (10, 30) magnetically coupled to the means of magnetic excitation,
- a measuring unit (3, 21) connected to the magnetic measuring transducer (10, 30) and suitable for providing a measurement of magnetic field circulation in the core
**characterised in that** the supple magnetic material of the supple magnetic core (11) has a low relative magnetic permeability comprising a supple or flexible matrix in which magnetic particles are dispersed.

2. Sensor according to claim 1, **characterised in that** the relative magnetic permeability of the magnetic core is less than 100 or less than 10 or less than 5.

3. Sensor according to claim 1 or 2, **characterised in that** the magnetic particles of the core (11) have sub-micrometric dimensions and preferably of nanometric order.

4. Sensor according to any one of claims 2 to 3, **characterised in that** the core (11) has a superparamagnetic behaviour.

5. Sensor according to any one of the previous claims, **characterised in that** the excitation coil (10) comprises at least one outgoing conductor (12) wound around the core so as to extend from a first end (13) to a second end (14) of the core and at least one return conductor (15) extending from the second end (14) of the outgoing conductor (12) to return to the vicinity of the first end (13).

6. Sensor according to claim 5, **characterised in that** the return conductor (15) extends within the core substantially along its central axis (Δ).

7. Sensor according to any one of claims 1 to 6, **characterised in that** the magnetic measurement transducer (10, 30) comprises at least one conductor wound around the elongated supple magnetic core.

8. Sensor according to any one of claims 1 to 7, **characterised in that** the excitation coil (10) forms in part at least the magnetic measurement transducer (10).

9. Sensor according to any one of claims 1 to 8, **characterised in that** at least one wound conductor (12, 25) forms contiguous turns.

10. Sensor according to any one of claims 1 to 9, **characterised in that** it comprises feedback means (22) suitable for maintaining the circulation of the field within a predefined range, preferably substantially close to zero.

11. Sensor according to any one of claims 1 to 10, **characterised in that** it comprises at least two substantially identical assemblies, each formed of an excitation coil, a magnetic core and a linked measuring transducer and preferably two assemblies only.

12. Sensor according to any one of claims 1 to 11, **characterised in that** it comprises at least one transducer (40) of the Rogowski type connected to a the measuring unit.

13. Sensor according to any one of claims 1 to 12, **characterised in that** it comprises means (17) for loop closure of the magnetic core.

14. Sensor according to any one of claims 1 to 13, **characterised in that** it comprises means for connection between the transducers and the excitation (3, 20) and the measuring (3, 21) units.

15. Direct or alternating current sensor, implementing a permanent or variable magnetic field circulation sensor according to any one of claims 1 to 14, **characterised in that** the measuring means are suitable for measuring a current circulating in a conductor (C) around which the assembly (2) formed by the excitation coils (10) and the core (11), is loop closed.
